# EUROPÄISCHE PATENTSCHRIFT

(11) **EP 3 870 736 B1**
(45) Veröffentlichungstag und Bekanntmachung des Hinweises auf die Patenterteilung: **22.11.2023**
(21) Anmeldenummer: 19795194.0
(22) Anmeldetag: 28.10.2019
(51) Int. Cl.: C23C 14/50, B05B 13/02, F16H 1/22, F16H 1/10

(54) **WERKSTÜCKTRÄGEREINRICHTUNG UND BESCHICHTUNGSANORDNUNG**
WORKPIECE CARRIER DEVICE AND COATING ARRANGEMENT
DISPOSITIF PORTE-PIÈCE ET DISPOSITIF DE REVÊTEMENT

(30) Priorität: 26.10.2018 DE 102018126862
(43) Veröffentlichungstag der Anmeldung: 01.09.2021
(73) Patentinhaber: Oerlikon Surface Solutions AG, Pfäffikon, 8808 Pfäffikon (CH)
(72) Erfinder: MEILER, Rudolf, 7220 Schiers (CH)
(74) Vertreter: MFG Patentanwälte Meyer-Wildhagen Meggle-Freund Gerhard PartG mbB
(86) Internationale Anmeldenummer: PCT/EP2019/079376
(87) Internationale Veröffentlichungsnummer: WO 2020/084164

(56) Entgegenhaltungen:
- EP-B1- 2 048 263
- CN-A- 105 586 577
- DE-A1-102004 027 989
- KR-B1- 101 646 698
- US-A- 3 853 091
- US-A1- 2002 094 383
- US-A1- 2012 103 265
- US-A1- 2015 136 029
- YALAMANCHILI K ET AL: "Exploring the high entropy alloy concept in (AlTiVNbCr)N", THIN SOLID FILMS, vol. 636, 15 July 2017 (2017-07-15), pages 346-352, XP085150875, ISSN: 0040-6090, DOI: 10.1016/J.TSF.2017.06.029

## Beschreibung

### GEBIET DER ERFINDUNG

Die vorliegende Offenbarung betrifft eine Werkstückträgereinrichtung zum Bewegen von Werkstücken mit einem um eine Hauptachse drehbaren Antriebsrad zur Aufnahme von Werkstückanordnungen und mehreren jeweils um eine Rotationsachse drehbaren, auf dem Antriebsrad angeordneten Antriebskörpern.

### HINTERGRUND DER ERFINDUNG

Solche Werkstückträgereinrichtungen werden zur Bearbeitung von Werkstücken vor allem in Vakuumanlagen und insbesondere zur Beschichtung der Werkstücke in Vakuumanlagen genutzt. Sie dienen dazu, die Werkstücke, die an mehreren Werkstückträgereinheiten angebracht sind, in einem Beschichtungsraum zu bewegen, um eine gleichmäßige Beschichtung aller freiliegenden Flächen der Werkstücke in dem Beschichtungsraum zu gewährleisten. Solche Werkstückträgereinrichtungen sind besonders dazu geeignet, zylindrische oder hülsenförmige Werkstücke in einem Beschichtungsraum zu bewegen. Dabei sind die Werkstücke kronen- bzw. kranzartig um die Hauptachse angeordnet und werden um die Hauptachse herum in dem Beschichtungsraum bewegt. Um eine gleichmäßige Beschichtung aller Flächen zu erreichen, insbesondere der zylindrischen Umfangsflächen, sind die Werkstücke dazu in drehbaren Halterungen angeordnet, die über die Antriebskörper um ihre eigene, die Rotationsachse, rotieren. Beim Beschichten bewegen sich die Werkstücke um die Hauptachse und um die jeweilige Rotationsachse, so dass alle Flächen durch das Beschichtungsmaterial im Beschichtungsraum bewegt werden.

Es gibt Werkstückträgereinrichtungen, bei denen die Werkstückträger oder Werkstückträgereinheiten über Kurbelmechanismen in Verbindung mit einer Exzenterscheibe um die Rotationsachse in Drehung versetzt werden. Solche Antriebe können jedoch bei relativ schweren Werkstückanordnungen problematisch sein, da unter Umständen vergleichsweise hohe Stellkräfte zur Betätigung der Kurbelantriebe erforderlich sind und dadurch die Kurbelantriebe ebenfalls relativ schwer und auf wendig herzustellen sind. Durch Unwuchten oder ähnliches kann auch das Problem bestehen, dass keine gleichförmige Rotation um die jeweiligen Rotationsachsen erzielbar ist und dadurch die Beschichtungsergebnisse unter Umständen unbefriedigend sein können. Weiterer Stand der Technik wird in dem Patentdokument US 2012/103265 A1 offenbart.

Über Zahnradgetriebe angetriebene Werkstückträger(einheiten) erfordern hohen Fertigungsaufwand für die Zahngeometrien und können wegen der hohen Temperaturschwankungen (zwischen 20° und 600° C) in einem Beschichtungsraum problematisch sein, da thermisch verursachte Änderungen der Geometrie die Funktion beeinträchtigen können.

Die Aufgabe der vorliegenden Erfindung besteht also darin, eine verbesserte Werkstückträgereinrichtung zur Verfügung zu stellen, bei der diese Nachteile wenigstens teilweise ausgeräumt sind.

### ZUSAMMENFASSUNG DER ERFINDUNG

Nach einem ersten Aspekt stellt die vorliegende Erfindung eine Werkstückträgereinrichtung gemäß Anspruch 1 bereit, die ein um eine Hauptachse drehbares Antriebsrad zur Aufnahme von Werkstückanordnungen, mehrere jeweils um eine Rotationsachse drehbare, auf dem Antriebsrad angeordneten Antriebskörpern mit jeweils einem Antriebsritzel und ein stillstehendes Antriebshohlrad mit einer Innenverzahnung aufweist, die mit den Antriebsritzeln kämmt. Dabei verlaufen die Rotationsachsen parallel zur Hauptachse und sind in einem konzentrisch zur Hauptachse verlaufenden Ringbereich des Antriebsrads angeordnet, so dass die Antriebskörper bei Drehung des Antriebsrads relativ zum Antriebshohlrad um ihre jeweiligen Rotationsachsen rotieren, wobei das Antriebshohlrad, die Antriebskörper mit ihren Antriebsritzeln so ausgebildet und zueinander angeordnet sind und zwischen Antriebshohlrad und Antriebsritzeln so ein Arbeitsspiel besteht, dass die Antriebswirkung im Betrieb gleichmäßig auf alle Antriebsritzel übertragen wird.

Nach einem zweiten Aspekt stellt die vorliegende Erfindung eine Beschichtungsanordnung gemäß Anspruch 10 bereit, die mit einer solchen Werkstückträgereinrichtung versehen ist.

Weitere Aspekte und Merkmale der vorliegenden Erfindung ergeben sich aus den abhängigen Ansprüchen, der beigefügten Zeichnung und der nachfolgenden Beschreibung bevorzugter Ausführungsformen.

### KURZBESCHREIBUNG DER ZEICHNUNG

Ausführungsformen der Erfindung werden nun beispielhaft und unter Bezugnahme auf die beigefügte Zeichnung beschrieben. Darin zeigt:
- Fig. 1: eine perspektivische Ansicht eines Ausführungsbeispiels einer erfindungsgemäßen Werkstückträgereinrichtung;
- Fig. 2: eine detaillierte Darstellung des Antriebsmechanismus der in Figur 1 dargestellten Werkstückträgereinrichtung mit einer vergrößerten Darstellung des Eingriffs der Antriebsritzel mit dem Antriebshohlrad;
- Fig. 3: eine Schnittdarstellung des in Figur 1 dargestellten Antriebsrades der erfindungsgemäßen Werkstückträgereinrichtung;
- Fig. 4: eine vergrößerte Schnittdarstellung des Antriebskörpers und
- Fig. 5: eine Explosionsdarstellung des Antriebsrades mit den Antriebskörpern einer erfindungsgemäßen Werkstückträgereinrichtung.

### BESCHREIBUNG VON AUSFÜHRUNGSFORMEN

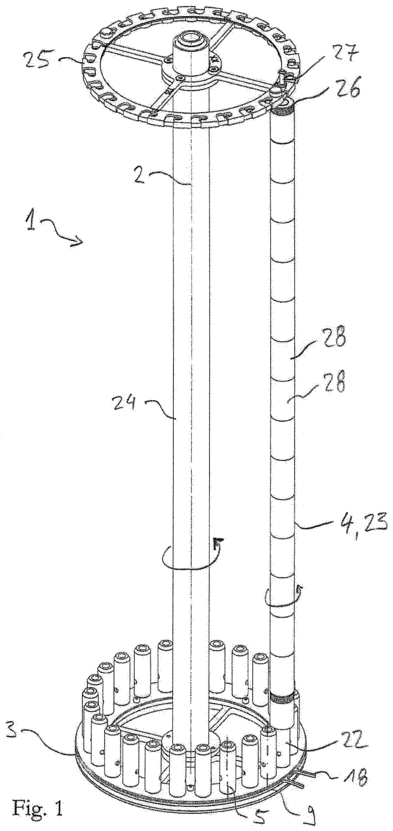

In Fig. 1 ist eine Ausführungsform in Übereinstimmung mit der vorliegenden Erfindung veranschaulicht. Vor einer detaillierten Beschreibung folgen zunächst allgemeine Erläuterungen zu den Ausführungsformen.

Die Werkstückträgereinrichtung gemäß dem ersten Aspekt der Erfindung ist durch ein Antriebs- bzw. Arbeitsspiel gekennzeichnet, das einen gleichmäßigen Antrieb aller Antriebskörper ermöglicht. Dieses Antriebsspiel ist gekennzeichnet durch ein besonderes Zusammenspiel der Abmessungen der Antriebsritzel und der Verzahnung des die Antriebsritzel umgebenden Hohlrades mit dem diese kämmen. Weiter ist es durch das Durchmesserverhältnis zwischen dem Antriebshohlrad und einem Ringkreis definiert, auf dem die Rotationsachsen angeordnet sind, um die die Antriebskörper rotieren. Schließlich ist das Arbeitsspiel auch durch die Art und die Geometrie der Innenverzahnung und der Zahnkränze der Ritzel definiert. Es ist so gewählt, dass auch temperaturbedingte Ausdehnungen bzw. Schrumpfungen berücksichtigt und neutralisiert werden, so dass der Betrieb in einem Temperaturbereich von ca. 600° C sichergestellt ist, insbesondere für korrosionsfeste Stähle (z.B. 1.4301 und ähnlich)

Als Verzahnung hat sich dabei die Evolventenverzahnung bewährt. Es können auch andere geeignete Verzahnungen realisiert werden.

Das Durchmesserverhältnis zwischen dem Rotationsachsenkreis (Ringkreis) und dem Nenndurchmesser (Zahnfußkreis- bzw. Zahnkopfkreisdurchmesser) des Antriebshohlrades ist dabei zwischen 0,75 und 0,9 wählbar. Das Verhältnis zwischen dem jeweiligen Nenndurchmesser (Fußkreis- bzw. Kopfkreisdurchmesser) der Ritzel und dem des Antriebshohlrades und dem liegt zwischen 0,1 und 0,3.

Dabei können von 3 bis 25 Antriebskörper in einem entsprechenden Hohlrad angeordnet werden. Das Übersetzungsverhältnis zwischen den Antriebsritzeln und der Innenverzahnung des Antriebshohlrades ist so gewählt, dass bei einer kompletten Drehung des Antriebsrades um 360° um die Hauptachse jeder Antriebskörper 3 bis 15 Umdrehungen vollzieht.

Das auf die Nenndurchmesser des Hohlrades bzw. des Ringkreises bezogene Arbeitsspiel beträgt für einen Durchmesserbereich von ca. 200 bis 300 mm 0,05 bis 0,6 mm vorzugsweise zwischen 0,1 bis 0,3 mm und insbesondere 0,1 mm. Durch die jeweiligen Zahnfußkreise, Zahnkopfkreise bzw. die im Betrieb wirkenden Teilkreise der gesamten Verzahnung wird das Hohlrad radial zu den im Eingriff stehenden Antriebsritzeln gelagert.

Es gibt Ausführungen, bei denen das Arbeitsspiel so bemessen ist, dass die Zahngeometrien der Antriebsritzel und des Antriebshohlrades in einem thermischen Schneidverfahren herstellbar sind, wobei das thermische Schneidverfahren insbesondere ein Laserschneidverfahren ist. Damit ist es möglich, die Wirkgeometrie der Antriebsritzel und der Innenverzahnung ohne aufwendige Nachbearbeitungen wie Schleifen oder Fräsen auszubilden, so dass die laserstrahlgeschnittenen Antriebsritzel mit einem ebenso hergestellten Antriebshohlrad ohne zusätzliche Nachbearbeitungen verwendbar sind.

Erfindungsgemäß ist das Antriebshohlrad verschieblich in einer senkrecht zur Hauptachse verlaufenden Einstellebene angeordnet. Eine solche schwimmende bzw. fliegende Lagerung des Antriebshohlrades erlaubt eine drehfeste Fixierung relativ zum Antriebsrad - beispielsweise an einem Maschinengestell - und gleichzeitig eine selbsteinstellende Arbeitsposition in der Einstellebene, die sich im Betrieb, also bei Rotation des Antriebsrades, ergibt. Auf diese Weise ist ein leichtgängiger, verschleißarmer Antrieb realisierbar.

Dabei gibt es Ausführungen, bei denen die Einstellebene durch eine zwischen dem Antriebsrad und dem Antriebshohlrad angeordneten Gleitring definiert ist, der mit dem Antriebshohlrad in der Einstellebene eine Gleitpaarung bildet. Durch diese Anordnung ist sichergestellt, dass eine leicht verstellbare Selbstzentrierung des Antriebshohlrades in der Gleitebene sichergestellt ist. Das Hohlrad kann dabei beispielsweise aus einem geeigneten Stahlwerkstoff hergestellt sein, während der Gleitring aus einem geeigneten Gleitlagerwerkstoff wie z.B. (Sinterwerkstoffe) herstellbar ist.

In einer Ausführung, bei welcher der Gleitring drehfest mit dem Antriebsrad verbunden ist, wird sichergestellt, dass die Gleitwirkung nur in der Einstellebene erfolgt, da sich der Gleitring im Betrieb zusammen mit Antriebsrad dreht und dabei am Antriebshohlrad entlang gleitet, so dass im Betrieb immer die niedrigere Gleitreibung zwischen Antriebshohlraum und Gleitring wirkt und das Hohlrad leicht verstellbar ist.

Es gibt Ausführungen, wobei die Antriebskörper hülsenförmig ausgebildet sind und jeweils drehbar auf einem im Antriebsrad fixierten Lagerdorn gelagert sind. Damit wird auf einfache Weise eine genaue Lagedefinition der Antriebskörper sichergestellt und die Lagerung ist durch die hülsenförmige Gestaltung vor äußeren Einflüssen geschützt.

Es gibt Ausführungen, bei denen innen im Antriebskörper zwischen Lagerdorn und Antriebskörper eine Lagerkugel angeordnet ist, welche die Tragfähigkeit und die Beweglichkeit der Antriebskörper auf dem Lagerdorn verbessert. Lagerdorn und Lagerkugel können dabei aus einem besonders harten Lagerwerkstoff hergestellt werden und können gegebenenfalls bei Verschleiß unabhängig von dem Antriebskörper selber ausgetauscht werden.

Es gibt Ausführungen, bei denen das Antriebsrad auf einer vertikalen Antriebswelle angeordnet ist und mit einem Trägerrad gekoppelt ist - über diese gemeinsame Antriebswelle - und zwischen Trägerrad und Antriebsrad stangenartige Werkstückträger derart koppelbar sind, dass deren Gewichtslast über das Trägerrad und die Antriebswirkung (Rotation um die Rotationsachsen) über die Antriebskörper erfolgt. Damit wird die Drehbarkeit der Antriebskörper um ihre Rotationsachse auf dem Antriebsrad verbessert, da die Lagerungen keine Vertikallasten durch das Gewicht der Werkstückträger und der daran gekoppelten Werkstücke aufnehmen muss.

Es gibt Ausführungen, bei denen die Werkstückträger jeweils an einem oberen Aufhängungsende einen Aufhängungskopf zur Koppelung mit dem Trägerrad und an einem unteren Antriebsende einen Kopplungskopf zur formschlüssigen und drehfesten Kopplung mit einem Antriebsende des Antriebskörpers aufweisen. Auf diese Weise lässt sich die Drehung und Aufnahme auch relativ schwerer Werkstückträgeranordnungen leicht realisieren, da die vertikalen Haltekräfte über das Aufhängungsende bzw. den dort ausgeführten Aufhängungskopf aufgenommen werden und der am unteren Ende angeordnete Kopplungskopf frei von vertikalen Gewichtslasten lediglich die Rotationsbewegung über das Antriebsende des Antriebskörpers aufnimmt und auf den Werkstückträger und die daran angeordneten Werkstücke überträgt.

Dabei gibt es Ausführungen, bei denen der Aufhängungskopf mit dem Kopplungskopf am Antriebsende über eine entnehmbare Verbindungsstange koppelbar ist und die Verbindungsstange am Werkstückträger angeordnete Werkstücke durchsetzt. Damit lassen sich mehrere hohle und gegebenenfalls auch unterschiedlich gestaltete Werkstücke gewissermaßen auf die Verbindungsstange auffädeln und können zwischen dem Aufhängungskopf und dem Kopplungskopf so fixiert werden, dass sie die Rotation der Antriebskörper synchron ausführen. Die drehfeste Kopplung der Werkstücke kann entweder formschlüssig oder kraftschlüssig - durch Verspannen der Werkstücke zwischen dem Aufhängungskopf und dem Kopplungskopf über die Verbindungsstange - realisiert werden.

Nun zurückkehrend zu den Figuren:
Figur 1 zeigt ein Ausführungsbeispiel einer erfindungsgemäßen Werkzeugträgereinrichtung 1 mit einem um eine Hauptachse 2 drehbaren Antriebsrad 3 zur Aufnahme von (hier 25) Werkstückanordnungen 4, die jeweils um Rotationsachsen 5 drehbar am Antriebsrad 3 angeordnet sind.

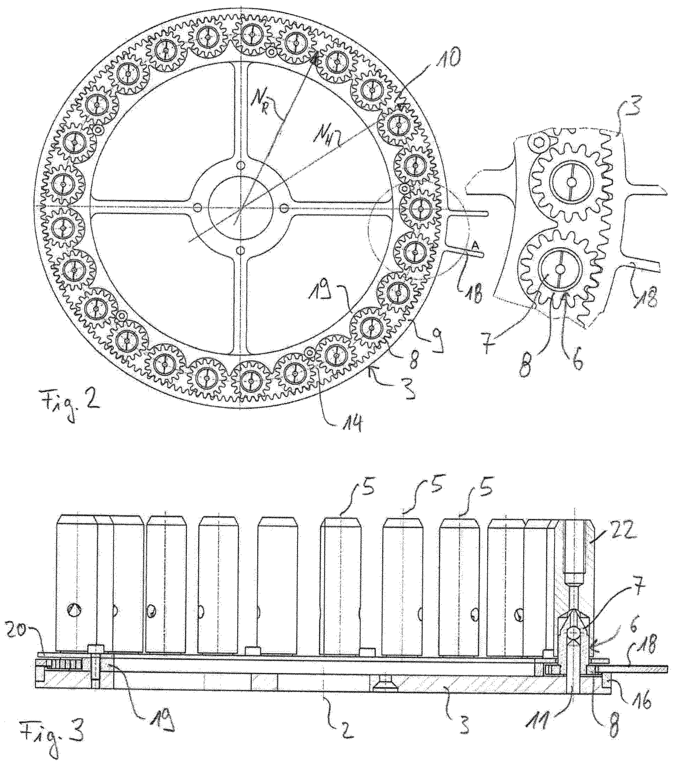

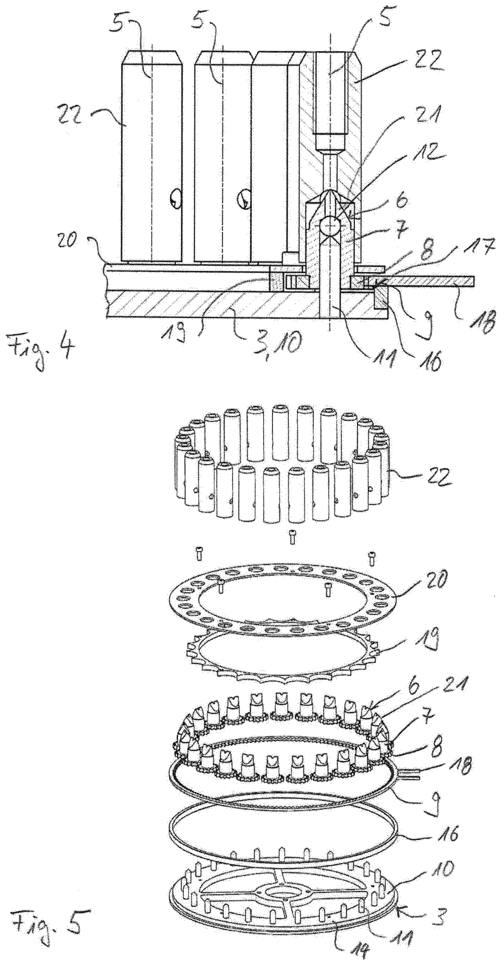

Funktion und Aufbau des Antriebsrades 3 werden nun zunächst anhand der Figuren 2 bis 5 erläutert. Das Antriebsrad 3 ist mit mehreren Antriebskörpern 6 versehen, die eine Antriebshülse 7 umfassen, die drehfest mit einem Antriebsritzel 8 versehen ist, die mit der Innenverzahnung eines Hohlrades 9 kämmt.

In dem dargestellten Ausführungsbeispiel sind 25 Antriebskörper 6 auf einem Antriebsring 10 des Antriebsrades 3 angeordnet. Jeder der Antriebskörper 6 ist auf einem Lagerdorn 11 gelagert, so dass dieser in das Innere der Antriebshülse 7 hineinragt und über eine Lagerkugel 12 die Antriebshülse 7 auf seiner Lagerspitze trägt. Dabei bleibt die untere Stirnfläche der Antriebshülse 7 und des Antriebsritzels 8 frei von der Oberfläche des Antriebsrades 3. So ist sichergestellt, dass sich der Antriebskörper 6 frei auf dem Lagerdorn 11 drehen kann. Alle Antriebskörper 6 sind auf diese Weise drehbar kreisförmig auf dem Antriebsring 10 des Antriebsrads 3 angeordnet. Die Rotationsachsen 5 sind dabei auf einem Ringkreis 14 angeordnet, der vom Hohlrad 9 umgeben ist, so dass die Hohlradverzahnung mit der Außenverzahnung der Antriebsritzel 8 kämmt.

Nenndurchmesser des Hohlrades 9 und der Durchmesser des Ringkreises 14 stehen in einem Verhältnis von etwa 1,1 bis 1,5 zueinander. Das Hohlrad 9 ist über einen Gleitring 16 in einer Einstellebene 17 verschieblich gelagert und über eine Anlenkgabel 18 drehfest zu einem nicht dargestellten Hauptgestell fixiert.

Ein Innenkranz 19 schirmt die Antriebsritzel 8 nach innen ab, die an ihrer Oberseite durch eine gelochte Abdeckscheibe 20 abgedeckt sind und aus der die Antriebshülsen 7 herausragen.

Bei Antrieb des Antriebsrades 3 um die Hauptachse 2 wälzen nun die Antriebsritzel 8 der Antriebskörper 6 am relativ zur Drehung feststehenden Hohlrad 9 und werden dadurch in Rotation um die Rotationsachsen 5 versetzt, so dass sich die Antriebskörper 6 um die Hauptachse 2 herum bewegen und sich dabei um ihre (eigene) Rotationsachse 5 drehen. Über ein Koppelprofil 21 an der Spitze der Antriebshülsen 7 sind diese formschlüssig mit einem Kopplungskopf 22 versehen, der Bestandteil eines Werkzeugträgers 23 ist, der einen Bestandteil der Werkstückanordnung 4 bildet.

Deren Aufbau und Funktion wird anhand der Figur 1 erläutert. Das Antriebsrad 3 ist über eine Antriebswelle 24 mit einem Trägerrad 25 gekoppelt, das zur Aufnahme der Werkstückanordnung 4 dient. Am oberen Ende der Werkstückanordnung 4 ist dabei ein Aufhängungskopf 26 vorgesehen, der über eine Verbindungsstange 27 mit dem Kopplungskopf verbunden ist. Dabei sind zwischen Aufhängungskopf 26 und Kopplungskopf 22 Werkstücke 28 (hier zylindrische Hülsen) auf der Verbindungsstange 27 aufgefädelt und drehfest miteinander gekoppelt, indem die Verbindungsstange zwischen dem Aufhängungskopf und dem Kopplungskopf verspannt wird.

Die so gebildete Werkstückanordnung 4 wird über den Kopplungskopf 26 in das Trägerrad 25 verdrehbar eingehängt und mit dem Kopplungskopf 22 drehfest mit dem Antriebskörper 6 gekoppelt. Bei Drehung des Antriebsrades 3 und des Trägerrades 25 über die Antriebswelle 24 wird dabei jede der Werkstückanordnungen, von denen in Figur 1 nur eine dargestellt ist, in Rotation um die Rotationsachsen 5 versetzt und um die Hauptachse 2 verdreht und sie bewegen sich dabei in einem Beschichtungsraum einer Beschichtungsanordnung 100, die durch eine gestrichelte Linie angedeutet ist.

Die Verzahnungen der Antriebsritzel 8 und des Hohlrades 9 sind in einem Laserschneidverfahren ausgebildet und zwischen dem Hohlrad 9 und den Antriebskörpern 6 bzw. den Antriebsritzeln 8 besteht ein Arbeitsspiel, das so ausgebildet ist, dass sich das Hohlrad 9 im Betrieb kräftearm um die verschiedenen Antriebsritzel 8 zentriert und diese gleichmäßig antreibt.

Das Arbeitsspiel beträgt dabei bezogen auf die Nenndurchmesser des Hohlrades 9 bzw. den Antriebskreisdurchmesser etwa 0,15 bis 1 %; bei einem Ringkreisdurchmesser N_{R} von ca. 150 mm und einem Nennkreisdurchmesser N_{H} des Hohlrades von ca. 170 mm beträgt das Arbeitsspiel zwischen 0,05 mm und 0,6 mm. Der Gleitring 16 ist aus einem gleitfähigen Werkstoff wie z. B. einem Sinterwerkstoff ausgeführt, während die anderen Bauteile im Wesentlichen aus korrosionsfesten Stahlwerkstoffen (z.B. 1.4301) ausgebildet sind.

Weitere Ausführungen und Variationen der Erfindung ergeben sich für den Fachmann im Rahmen der Ansprüche.

### BEGZUGSZEICHENLISTE

1 Werkstückträgereinrichtung
2 Hauptachse
3 Antriebsrad
4 Werkstückanordnung
5 Rotationsachse
6 Antriebskörper
7 Antriebshülse
8 Antriebsritzel
9 Hohlrad
10 Antriebsring
11 Lagerdorn
12 Lagerkugel
14 Ringkreis
15 Hohlradverzahnung
16 Gleitring
17 Einstellebene
18 Anlenkgabel
19 Innenkranz
20 Abdeckscheiben
21 Koppelprofil
22 Kopplungskopf
23 Werkstückträger
24 Antriebswelle
25 Trägerrad
26 Aufhängungskopf
27 Verbindungsstange
100 Beschichtungsanordnung
N_{R} Ringkreisdurchmesser
N_{H} Nenndurchmesser Hohlrad

## Patentansprüche

1. Werkstückträgereinrichtung (1) mit:
einem um eine Hauptachse (2) drehbaren Antriebsrad (3) zur Aufnahme von Werkstückanordnungen (4),
mehreren, jeweils um eine Rotationsachse (5) drehbaren, auf dem Antriebsrad (3) angeordneten Antriebskörpern (6) mit jeweils einem Antriebsritzel (8) und
einem stillstehenden Antriebshohlrad (9) mit einer Innenverzahnung, die mit den Antriebsritzeln (8) kämmt,
wobei die Rotationsachsen (5) parallel zur Hauptachse (2) verlaufen und in einem konzentrisch zur Hauptachse (2) verlaufenden Ringbereich des Antriebsrads (3) angeordnet sind, so dass
die Antriebskörper (6) bei Drehung des Antriebsrads (3) relativ zum Antriebshohlrad (9) um ihre jeweiligen Rotationsachsen (5) rotieren, wobei
das Antriebshohlrad (9) verschieblich in einer senkrecht zur Hauptachse verlaufenden Einstellebene (17) angeordnet ist und die Antriebskörper (6) mit ihren Antriebsritzeln (8) so ausgebildet und zueinander angeordnet sind, so dass zwischen Antriebshohlrad (9) und Antriebsritzeln (8) so ein Arbeitsspiel (S) besteht, dass eine Antriebswirkung des Antriebshohlrads (9) im Betrieb gleichmäßig auf alle Antriebsritzel (8) übertragen wird.

2. Werkstückträgereinrichtung (1) nach Anspruch 1, wobei das Arbeitsspiel (S) auf einen Nennkreisdurchmesser (N_{H}) des Antriebshohlrades (9) bezogen zwischen 0,15 und 1 % beträgt, so dass die Zahngeometrien der Antriebsritzel (8) und des Antriebshohlrades (9) in einem thermischen Schneidverfahren herstellbar sind.

3. Werkstückträgereinrichtung (1) nach Anspruch 1 oder 2, wobei das thermische Schneidverfahren ein Laserschneidverfahren ist.

4. Werkstückträgereinrichtung (1) nach Anspruch 1, 2 oder 3, wobei die Einstellebene (17) durch einen zwischen Antriebsrad (3) und Antriebshohlrad (9) angeordneten Gleitring (16) definiert ist, der mit dem Antriebshohlrad (9) in der Einstellebene (17) eine Gleitpaarung bildet.

5. Werkstückträgereinrichtung (1) nach einem der Ansprüche 1 bis 4, wobei die Antriebskörper (6) hülsenförmig ausgebildet sind und jeweils auf einen im Antriebsrad (3) fixierten Lagerdorn (11) drehbar gelagert sind.

6. Werkstückträgereinrichtung (1) nach Anspruch 5, wobei innen im Antriebskörper (6) zwischen Lagerdorn (11) und Antriebskörper (6) eine Lagerkugel (12) angeordnet ist.

7. Werkstückträgereinrichtung (1) nach einem der Ansprüche 1 bis 6 wobei das Antriebsrad (3) auf einer vertikalen Antriebswelle (24) angeordnet ist und mit einem Trägerrad (25) gekoppelt ist und zwischen Trägerrad (25) und Antriebsrad (3) stangenartige Werkstückträger (23) derart koppelbar sind, dass deren Gewichtslast über das Trägerrad (25) und die Antriebswirkung über die Antriebskörper (6) erfolgt.

8. Werkstückträgereinrichtung (1) nach Anspruch 7, wobei die Werkstückträger (23) jeweils an einem oberen Aufhängungsende einen Aufhängungskopf (26) zur Kopplung mit dem Trägerrad (25) und an einem unteren Antriebsende einen Kopplungskopf (22) zur formschlüssigen und drehfesten Kopplung mit einem Antriebsende des Antriebskörpers (6) aufweisen.

9. Werkstückträgereinrichtung (1) nach Anspruch 8, wobei der Aufhängungskopf (26) mit dem Antriebsende über eine entnehmbare Verbindungsstange (27) koppelbar ist und die Verbindungsstange (27) am Werkstückträger angeordnete Werkstücke (28) durchsetzt.

10. Beschichtungsanordnung (10) mit einer Werkstückträgereinrichtung (1) nach einem der Ansprüche 1 bis 9.

## Claims

1. A workpiece carrier device (1), comprising:
a drive gear (3) for receiving workpiece arrangements (4), which is rotatable about a main axis (2)
a number of drive bodies (6), which are arranged on the drive gear (3), are respectively rotatable about an axis of rotation (5) and each have a drive pinion (8) and
a stationary driving ring gear (9) with an internal toothing, which meshes with the drive pinions (8),
wherein the axes of rotation (5) extend parallel to the main axis (2) and are arranged in an annular region of the drive gear (3) that runs concentrically in relation to the main axis (2), so that,
when the drive gear (3) rotates relative to the driving ring gear (9), the drive bodies (6) rotate about their respective axes of rotation (5), wherein
the driving ring gear (9) is slidably arranged in an adjustment plane (17) running perpendicular to the main axis and the drive bodies (6) with their drive pinions (8) are formed and arranged in relation to one another, such that a working clearance (S) is provided between driving ring gear (9) and drive pinions (8) such that a driving action of the driving ring gear (9) is transferred to all drive pinions (8) equally during operation.

2. The workpiece carrier device (1) according to claim 1, wherein the working clearance (S) with respect to a nominal circle diameter (NH) of the driving ring gear (9) is between 0.15 and 1 %, so that the tooth geometries of the drive pinions (8) and of the driving ring gear (9) can be produced in a thermal cutting process.

3. The workpiece carrier device (1) according to claim 1 or 2, wherein the thermal cutting process is a laser cutting process.

4. The workpiece carrier device (1) according to claim 1, 2 or 3, wherein the adjustment plane (17) is defined by a slide ring (16) arranged between drive gear (3) and driving ring gear (9), which slide ring forms a sliding pair with the driving ring gear (9) in the adjustment plane (17).

5. The workpiece carrier device (1) according to any of claims 1 to 4, wherein the drive bodies (6) are sleeve-shaped and are each rotatably mounted on a bearing pin (11) fixed in the drive gear (3).

6. The workpiece carrier device (1) according to claim 5, wherein a bearing ball (12) is arranged inside the drive body (6) between bearing pin (11) and drive bodies (6).

7. The workpiece carrier device (1) according to any of claims 1 to 6, wherein the drive gear (3) is arranged on a vertical drive shaft (24) and is coupled to a carrier gear (25) and bar-type workpiece carriers (23) are coupled between carrier gear (25) and drive gear (3) in such a way that the weight load thereof is applied via the carrier gear (25) and the driving action is applied via the drive bodies (6).

8. The workpiece carrier device (1) according to claim 7, wherein each of the workpiece carriers (23) has at an upper suspension end a suspension head (26) that is coupled to the carrier gear (25) and at a lower drive end a coupling head (22) that is interlockingly coupled to a drive end of the drive body (6) and coupled thereto for conjoint rotation.

9. The workpiece carrier device (1) according to claim 8, wherein the suspension head (26) can be coupled to the drive end via a removable connecting rod (27) and the connecting rod (27) passes through workpieces (28) arranged on the workpiece carrier.

10. A coating arrangement (10) comprising a workpiece carrier device (1) according to any of claims 1 to 9.

## Revendications

1. Dispositif porte-pièce (1) comprenant :
une roue d'entraînement (3) pouvant tourner autour d'un axe principal (2) et destinée à recevoir des ensembles de pièces à usiner (4),
plusieurs corps d'entraînement (6) disposés sur la roue d'entraînement (3) et pouvant tourner chacun autour d'un axe de rotation (5), avec chacun un pignon d'entraînement (8), et
une roue creuse d'entraînement (9) immobile avec une denture intérieure qui s'engrène avec les pignons d'entraînement (8),
les axes de rotation (5) s'étendant parallèlement à l'axe principal (2) et étant disposés dans une zone annulaire de la roue d'entraînement (3) s'étendant de manière concentrique par rapport à l'axe principal (2), de sorte que
lors de la rotation de la roue d'entraînement (3) par rapport à la roue creuse d'entraînement (9), les corps d'entraînement (6) tournent autour de leurs axes de rotation (5) respectifs, dans lequel
la roue creuse d'entraînement (9) est disposée de manière coulissante dans un plan de réglage (17) perpendiculaire à l'axe principal et les corps d'entraînement (6) avec leurs pignons d'entraînement (8) sont conçus et disposés les uns par rapport aux autres de telle sorte qu'il existe entre la roue creuse d'entraînement (9) et les pignons d'entraînement (8) un jeu de travail (S) tel qu'un effet d'entraînement de la roue creuse d'entraînement (9) est transmise de manière uniforme à tous les pignons d'entraînement (8) pendant le fonctionnement.

2. Dispositif porte-pièce (1) selon la revendication 1, dans lequel le jeu de travail (S) rapporté à un diamètre nominal (N_{H}) de la roue creuse d'entraînement (9) est compris entre 0,15 et 1 %, de sorte que les géométries de denture des pignons d'entraînement (8) et de la roue creuse d'entraînement (9) peuvent être fabriquées dans un procédé de découpe thermique.

3. Dispositif porte-pièce (1) selon la revendication 1 ou 2, dans lequel le procédé de découpe thermique est un procédé de découpe laser.

4. Dispositif porte-pièce (1) selon la revendication 1, 2 ou 3, dans lequel le plan de réglage (17) est défini par une bague de glissement (16) disposée entre la roue d'entraînement (3) et la roue creuse d'entraînement (9), laquelle forme, avec la roue creuse d'entraînement (9), un couple de glissement dans le plan de réglage (17).

5. Dispositif porte-pièce (1) selon l'une des revendications 1 à 4, dans lequel les corps d'entraînement (6) sont réalisés en forme de douille et sont montés chacun de manière rotative sur un mandrin de palier (11) fixé dans la roue d'entraînement (3).

6. Dispositif porte-pièce (1) selon la revendication 5, dans lequel une bille de palier (12) est disposée à l'intérieur du corps d'entraînement (6) entre le mandrin de palier (11) et le corps d'entraînement (6).

7. Dispositif porte-pièce (1) selon l'une des revendications 1 à 6, dans lequel la roue d'entraînement (3) est disposée sur un arbre d'entraînement vertical (24) et est couplée à une roue de support (25), et des porte-pièces (23) en forme de tige entre la roue de support (25) et la roue d'entraînement (3) peuvent être couplés de telle sorte que leur charge pondérale s'effectue à travers la roue de support (25) et l'effet d'entraînement s'effectue à travers les corps d'entraînement (6).

8. Dispositif porte-pièce (1) selon la revendication 7, dans lequel les porte-pièces (23) présentent chacun, à une extrémité de suspension supérieure, une tête de suspension (26) pour le couplage avec la roue de support (25) et, à une extrémité d'entraînement inférieure, une tête de couplage (22) pour le couplage par complémentarité de forme et fixe en rotation avec une extrémité d'entraînement du corps d'entraînement (6).

9. Dispositif porte-pièce (1) selon la revendication 8, dans lequel la tête de suspension (26) peut être couplée à l'extrémité d'entraînement à travers une tige de liaison (27) amovible, et la tige de liaison (27) traverse des pièces à usiner (28) disposées sur le porte-pièce.

10. Dispositif de revêtement (10) comprenant un dispositif porte-pièce (1) selon l'une des revendications 1 à 9.
